# EUROPEAN PATENT APPLICATION

(11) **EP 4 056 947 A1**
(43) Date of publication of application: **14.09.2022**
(21) Application number: 21216818.1
(22) Date of filing: 22.12.2021
(51) Int. Cl.: G01B 11/25, G02B 27/42, G06T 7/521, G06V 10/141, G06V 10/145, G06V 40/16

(54) **LIGHT PROJECTION APPARATUS**

(30) Priority: 09.02.2021 US 202117170917
(71) Applicant: Himax Technologies Limited, Tainan City 74148 (TW)
(72) Inventor: HSIAO, Ming-Shu, 74148 TAINAN CITY (TW)
(74) Representative: Cabinet Beaumont

(57) **Abstract**

A light projection apparatus is disclosed, which includes a light source, an adjustable optical element and a diffractive optical element. The light source is configured to emit light. The adjustable optical element is arranged over the light source for refracting the light. The adjustable optical element is position adjustable or effective focal length adjustable. The diffractive optical element is arranged over the adjustable optical element for diffracting the light onto a region of space.

## Description

### BACKGROUND

### Field of the Invention

The invention relates to a light projection apparatus, and more particularly to a light projection apparatus which integrates functions of structured light projection and flood light projection.

### Description of Related Art

3D stereoscopic image sensing technologies have been gradually adopted for various applications, such as facial recognition and obstacle detection. For facial recognition, a flood illuminator is generally used for verifying a human face, while a structured light projector is generally used to calculate surface profiles of the human face. Some conventional electronic devices, such as mobile phones, include a flood illuminator and a structured light projector to perform a facial recognition function for various applications, such as device unlocking and mobile payments.

### SUMMARY

An objective of the invention is to provide a light projection apparatus which integrates functions of structured light projection and flood light projection for reducing manufacturing cost.

One aspect of the invention directs to a light projection apparatus which includes a light source, an adjustable optical element and a diffractive optical element (DOE). The light source is configured to emit light. The adjustable optical element is arranged over the light source for refracting the light. The adjustable optical element is position adjustable or effective focal length adjustable. The DOE is arranged over the adjustable optical element for diffracting the light onto a region of space.

In accordance with one or more embodiments of the invention, the light projected onto the region of space has a structured light pattern if the light source is on a focus plane of the adjustable optical element, and wherein the light projected onto the region of space has a flood light pattern if the light source is defocused from the focus plane of the adjustable optical element.

In accordance with one or more embodiments of the invention, the light source is defocused from the focus plane of the adjustable optical element by about 200 microns to about 600 microns for flood light projection onto the region of space.

In accordance with one or more embodiments of the invention, the DOE is a two-dimensional fan out DOE.

In accordance with one or more embodiments of the invention, the light source is a vertical cavity surface emitting laser (VCSEL) array.

In accordance with one or more embodiments of the invention, the light projection apparatus further includes a step motor that is configured to adjust the position of the adjustable optical element relative to the light source.

In accordance with one or more embodiments of the invention, the adjustable optical element is a liquid crystal (LC) lens, and the light projection apparatus further includes an LC lens driver that is configured to apply voltage signals on the LC lens to adjust an effective focal length of the LC lens.

In accordance with one or more embodiments of the invention, the light projection apparatus further includes a light sensor that is configured to detect the light reflected at the region of space.

In accordance with one or more embodiments of the invention, the light sensor is a structured light sensor, a time of flight (ToF) sensor, or a combination thereof.

Another aspect of the invention is directed to a light projection apparatus which includes first and second light sources, first and second optical elements, and first and second DOEs. The first light source is configured to emit first light. The first optical element is arranged over the first light source for refracting the first light. The first light source is on a focus plane of the first optical element. The first DOE is arranged over the first optical element for diffracting the first light onto a region of space. The second light source is configured to emit second light. The second optical element is arranged over the second light source for refracting the second light. The second light source is defocused from a focus plane of the second optical element. The second DOE is arranged over the second optical element for diffracting the second light onto the region of space. The first light source and the first optical element are respectively the same as the second light source and the second optical element.

In accordance with one or more embodiments of the invention, the first and second DOEs are the same.

### BRIEF DESCRIPTION OF THE DRAWINGS

The foregoing aspects and many of the accompanying advantages of this invention will become more readily appreciated as the same becomes better understood by reference to the following detailed description, when taken in conjunction with the accompanying drawings.
FIG. 1 is a schematic diagram illustrating a light projection apparatus in accordance with some embodiments of the invention.
FIG. 2 exemplarily illustrates components of the light projection apparatus shown in FIG. 1 for projecting a structured light pattern onto a region of space in accordance with one example.
FIG. 3 exemplarily illustrates components of the light projection apparatus shown in FIG. 1 for projecting a flood light pattern onto a region of space in accordance with one example.
FIG. 4 is a schematic diagram illustrating a light projection apparatus in accordance with some embodiments of the invention.
FIG. 5 is a schematic diagram illustrating a light projection apparatus in accordance with some embodiments of the invention.
FIG. 6 is a schematic diagram illustrating a light projection apparatus in accordance with some embodiments of the invention.
FIG. 7 shows a structured light projection and a flood light projection from the same light source and through the same 3x3 fan out DOE of a light projection apparatus as well as being captured by the same light sensor.
FIG. 8 shows a structured light projection and a flood light projection from the same light source and through the same 9x11 fan out DOE with a particular intensity design as well as being captured by the same light sensor.
FIG. 9 shows a structured light projection and a flood light projection from the same light source and through the same 9x11 fan out DOE with another intensity design as well as being captured by the same light sensor.

### DETAILED DESCRIPTION

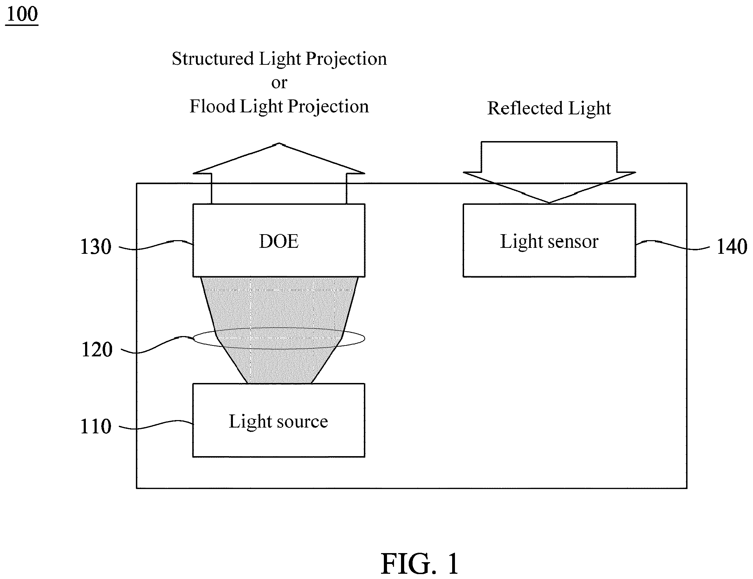

FIG. 1 is a schematic diagram illustrating a light projection apparatus 100 in accordance with some embodiments of the invention. The light projection apparatus 100 may be, for example, a mobile phone, a tablet or a smartglass, but the invention is not limited thereto. As shown in FIG. 1, the light projection apparatus 100 includes a light source 110, an adjustable optical element 120, a diffractive optical element (DOE) 130 and a light sensor 140. The light source 110 is configured to emit light. The emitted light may be in a visible wavelength range or in a near-infrared wavelength range, but the invention is not limited thereto. The light source 110 may be a laser source, such as a vertical cavity surface emitting laser (VCSEL), an array of VCSELs (VCSEL array), a distributed feedback (DFB) semiconductor laser, or another suitable light source. The adjustable optical element 120 is arranged over the light source 110 for refracting the light emitted by the light source 110 towards the DOE 130. The position and/or the efficient focal length of the adjustable optical element 120 may be adjusted to determine a distribution of the refracted light components onto the DOE 130. The adjustable optical element 120 may be a convex lens, a concave lens, a liquid crystal (LC) lens, or the like. The DOE 130 is arranged over the light source 110 for converting the refracted light into a projection light pattern and projecting the projection light pattern onto a region of space. The DOE 130 may have a grating structure, a microlens structure, a Fresnel structure, a holographic optical element (HOE) structure, or another structure suitable for diffracting light, such that the refracted light is converted to the projection light pattern by the diffraction principle of the DOE 130. The DOE 130 may be a two-dimensional fan out DOE that projects the same structured light pattern in multiple areas of the projected region of space. The light sensor 140 is configured to detect the optical pattern onto the region of space for capturing an image corresponding to the optical pattern. The light sensor 140 may be a structured light sensor, a time of flight (ToF) sensor, or a combination thereof, and may include a charge-coupled device (CCD) sensor, a complementary metal-oxide semiconductor (CMOS) sensor, or the like. Depending on the arrangement of the light source 110, the adjustable optical element 120 and the DOE 130, the light projection apparatus 100 may be operated as a structured light projector (also referred to as a dot projector) or a flood projector (also referred to as a flood illuminator).

The DOE 130 may be change to be optically interposed between the light source 110 and the adjustable optical element 120 for a certain embodiments. In addition, the adjustable optical element 120 and the DOE 130 may be integrated into a singular module.

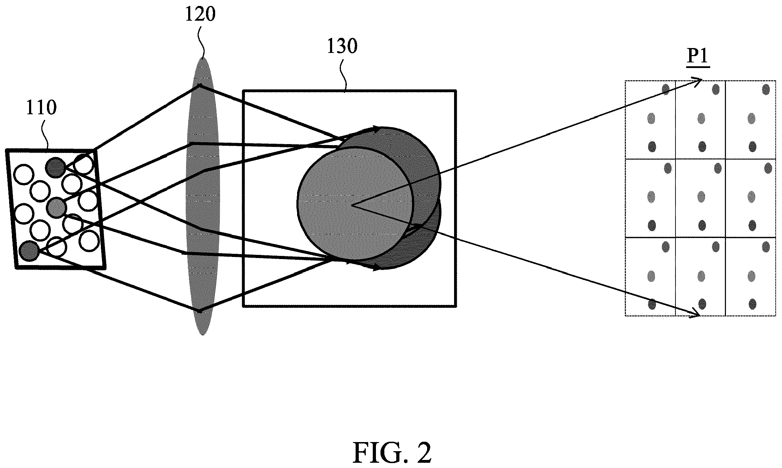

FIG. 2 exemplarily illustrates components of the light projection apparatus 100 for projecting a structured light pattern onto a region of space P1 in accordance with one example. In this example, the light source 110 is an array of VCSEL illuminators, and the DOE 130 is a 3x3 fan out DOE that projects the same structured light pattern in 3x3 areas of the projected region of space. With the light source 110 on a focus plane of the adjustable optical element 120, the DOE 130 patterns the refracted light to generate a structured light pattern, and projects the structured light pattern onto a region of space P1.

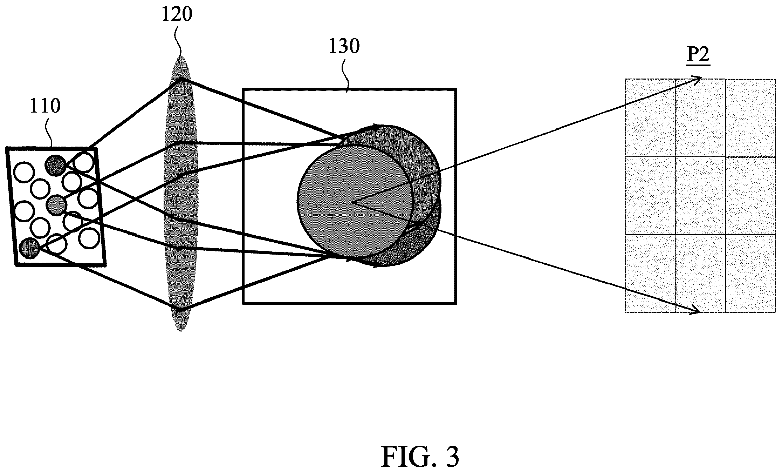

FIG. 3 exemplarily illustrates components of the light projection apparatus 100 for projecting a flood light pattern onto a region of space P2 in accordance with one example. The light source 110 and the DOE 130 may be respectively the same as those in the example corresponding to FIG. 2. With the light source 110 defocused from the focus plane of the adjustable optical element 120, the DOE 130 patterns the refracted light to generate a flood light pattern, and projects the flood light pattern onto a region of space P2. The amount of defocusing for flood illumination may be determined from the density of the light source 110. In general, the amount of defocusing is relatively large for flood illumination if the density of the light source 110 is relatively sparse. According to the designs of the light source 110, the adjustable optical element 120 and the DOE 130, the light source 110 may be defocused from the focus plane of the adjustable optical element 120 by about 200 microns to about 600 microns.

According to the above descriptions, the adjustable optical element 120 may be configured to focus the emitted light for projecting structured light, and may be controlled to defocus the emitted light for projecting flood light, so as to achieve integration of the functions of structured light projection and flood light projection in one light projection apparatus, thereby reducing manufacturing cost.

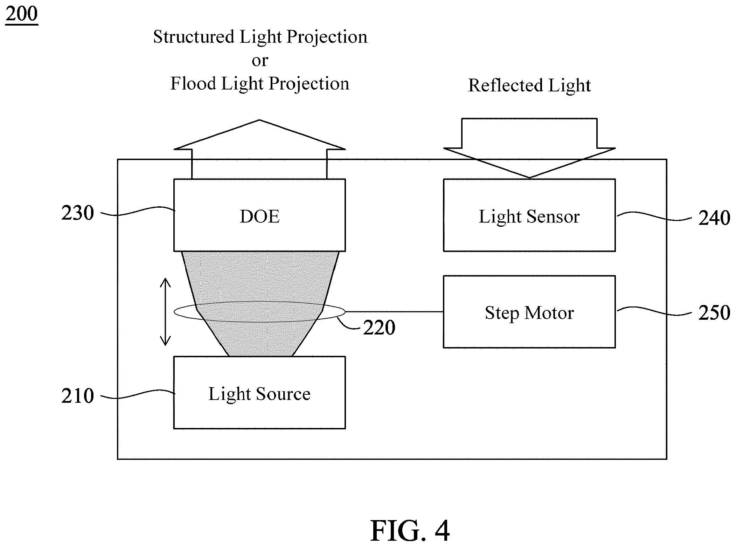

FIG. 4 is a schematic diagram illustrating a light projection apparatus 200 in accordance with some embodiments of the invention. As shown in FIG. 4, the light projection apparatus 200 includes a light source 210, an adjustable optical element 220, a DOE 230, a light sensor 240 and a step motor 250. The light source 210, the DOE 230 and the light sensor 240 may be respectively the same as or similar to the light source 110, the DOE 130 and the light sensor 140 shown in FIG. 1. The adjustable optical element 220 may be a collimating lens, such as a convex lens, a concave lens, or the like, and the step motor 250 may be configured to adjust the position of the adjustable optical element 220 relative to the step motor 250. The light projection apparatus 200 works as a structured light projector that projects structured light (such as dots and/or lines) in a condition where the step motor 250 moves the adjustable optical element 220 to the position distant from the light source 210 by about the efficient focal length of the adjustable optical element 220. Oppositely, the light projection apparatus 200 works as a flood light projector that projects flood light (such as spot light) if the step motor 250 moves the adjustable optical element 220 so that the light source 210 is defocused from the focus plane of the adjustable optical element 220.

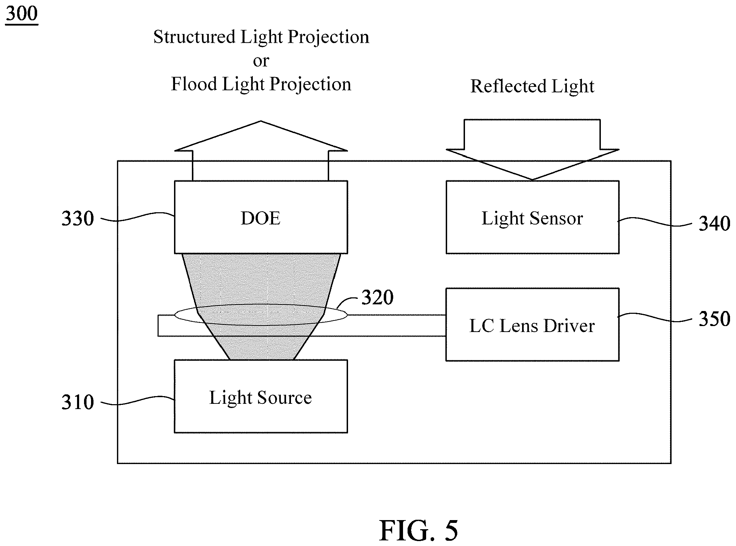

FIG. 5 is a schematic diagram illustrating a light projection apparatus 300 in accordance with some embodiments of the invention. As shown in FIG. 5, the light projection apparatus 300 includes a light source 310, an adjustable optical element 320, a DOE 330, a light sensor 340 and an LC lens driver 350. The light source 310, the DOE 330 and the light sensor 340 may be respectively the same as or similar to the light source 110, the DOE 130 and the light sensor 140 shown in FIG. 1. The adjustable optical element 320 may be arranged in a position distant from the light source 310 by about the effective focal length of the adjustable optical element 320 without being driven by the LC lens driver 350. The adjustable optical element 320 is an LC lens, and the LC lens driver 350 may adjust the effective focal length of the adjustable optical element 320 by applying voltage signals respectively on two opposite electrodes (not shown) of the adjustable optical element 320. The light projection apparatus 300 works as a structured light projector that projects structured light (such as dots and/or lines) if the LC lens driver 350 does not apply voltage signals on the adjustable optical element 320. Oppositely, the light projection apparatus 300 works as a flood light projector that projects flood light (such as spot light) if the LC lens driver 350 applies voltage signals on the adjustable optical element 320.

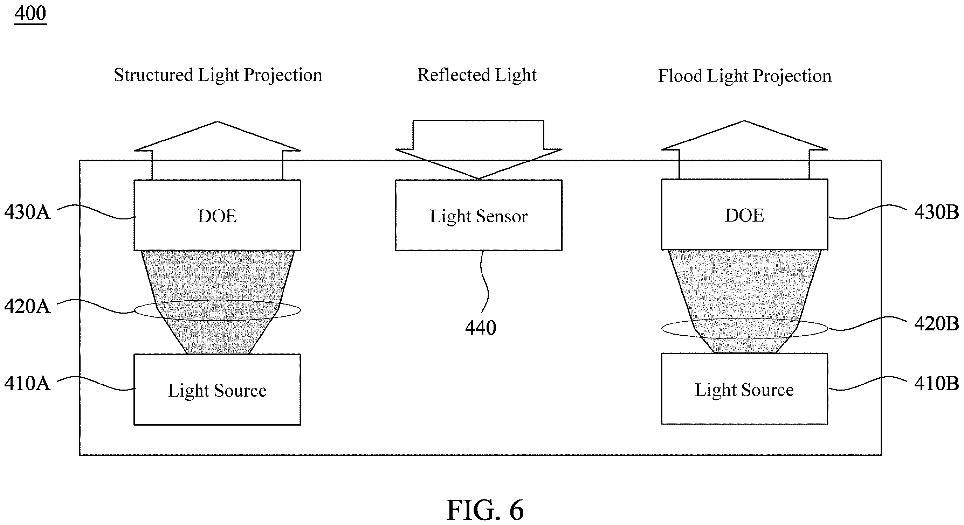

FIG. 6 is a schematic diagram illustrating a light projection apparatus 400 in accordance with some embodiments of the invention. As shown in FIG. 6, the light projection apparatus 400 includes light sources 410A-410B, optical elements 420A-420B, DOEs 430A-430B and a light sensor 440. The light sources 410A, 410B, the DOEs 430A, 430B and the light sensor 440 may be respectively the same as or similar to the light source 110, the DOE 130 and the light sensor 140 shown in FIG. 1. The light source 410A, the optical element 420A and the DOE 430A may be configured as a structured light projector, while the light source 410B, the optical element 420B and the DOE 430B may be configured as a flood light projector. The light sensor 440 is configured to receive reflected light from the DOE 430A or the DOE 430B. The DOE 430B may be replaced with a microlens array for a certain embodiments.

In some embodiments, the light source 410A, the optical element 420A and the DOE 430A are respectively the same as the light source 410B, the optical element 420B and the DOE 430B, the light source 410A is on a focus plane of the optical element 420A, and the light source 410B is defocused from a focus plane of the optical element 420B. Depending from system designs, the light source 410A/410B, the optical element 420A/420B and the DOE 430A/430B may be respectively the same as or similar to the light source 210, the adjustable optical element 220 and the DOE 230 shown in FIG. 4, or may be respectively the same as or similar to the light source 310, the adjustable optical element 320 and the DOE 330 shown in FIG. 5.

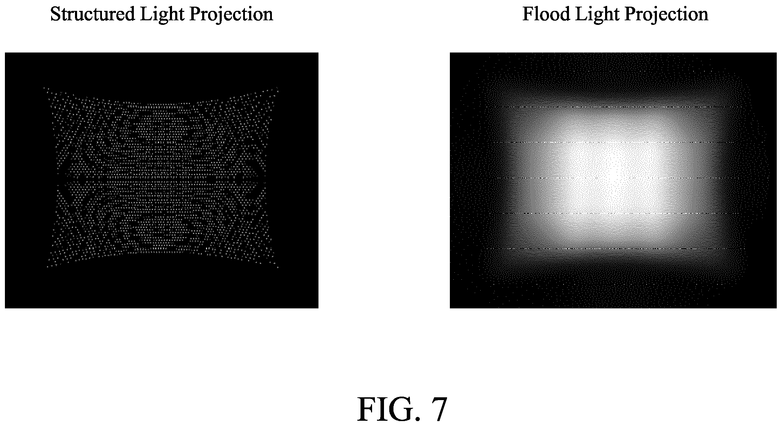

FIG. 7 shows a structured light projection and a flood light projection from the same light source and through the same 3x3 fan out DOE of a light projection apparatus (e.g. the light projection apparatus shown in FIG. 1) as well as being captured by the same light sensor. If the light source is on a focus plane of the adjustable optical element, the optical pattern projected through the fan out DOE is as the structured light projection shown in FIG. 7. As the light source is defocused from the adjustable optical element by 200 microns, the optical pattern projected through the fan out DOE is as the flood light projection shown in FIG. 7. For the same light projection apparatus, the field of view (FOV) corresponding to the flood light projection is less than that corresponding to the structured light projection.

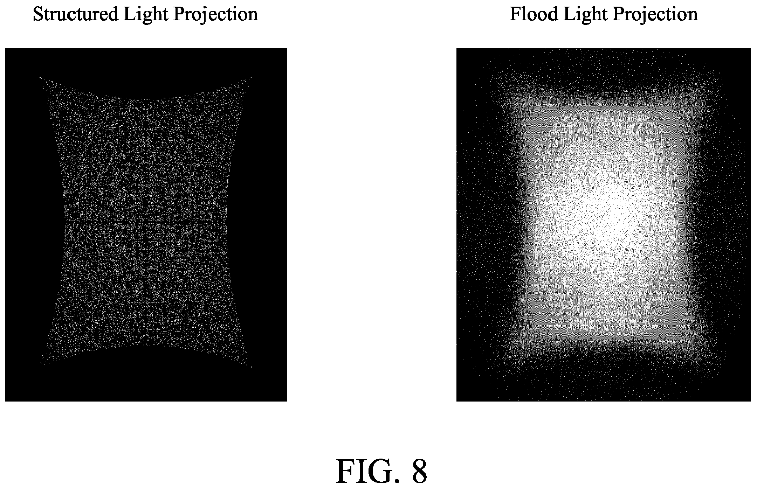

FIG. 8 shows a structured light projection and a flood light projection from the same light source and through the same 9x11 fan out DOE with a particular intensity design as well as being captured by the same light sensor. In comparison with the structured light projection and the flood light projection shown in FIG. 7, for the same FOV, the structured light projection shown in FIG. 8 has more projected dots (the dot density is relatively large), and the flood light projection shown in FIG. 8 is more diffused. As can be seen from FIGs. 7 and 8, the DOE with a larger fan out number may have more degrees of freedom for profile design.

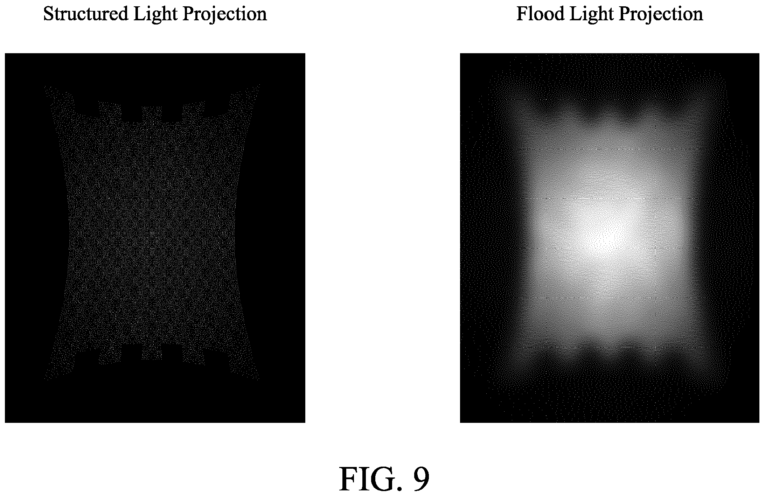

FIG. 9 shows a structured light projection and a flood light projection from the same light source and through the same 9x11 fan out DOE with another intensity design as well as being captured by the same light sensor. As can be seen from FIGs. 8 and 9, the patterns of the structured light projection and the flood light projection may change with the structural pattern of the DOE. The structural pattern of the DOE may be designed by utilizing an algorithm for optimization, such as an iterative Fourier Transform algorithm (IFTA), a simulated annealing algorithm, and/or the like, and such algorithm may be implemented in a software program executed by a processor, such as a central processing unit (CPU).

## Claims

1. A light projection apparatus (100,200,300) **characterized by** comprising:
a light source (110,210,310) configured to emit light;
an adjustable optical element (120,220,320) arranged over the light source (110,210,310) for refracting the light, wherein the adjustable optical element (120,220,320) is position adjustable or effective focal length adjustable; and
a diffractive optical element (DOE) (130,230,330) arranged over the adjustable optical element (120,220,320) for diffracting the light onto a region of space.

2. The light projection apparatus (100,200,300) of claim 1, **characterized in that** the light projected onto the region of space has a structured light pattern if the light source (110,210,310) is on a focus plane of the adjustable optical element (120,220,320), and wherein the light projected onto the region of space has a flood light pattern if the light source (110,210,310) is defocused from the focus plane of the adjustable optical element (120,220,320).

3. The light projection apparatus (100,200,300) of claim 2, **characterized in that** the light source (110,210,310) is defocused from the focus plane of the adjustable optical element (120,220,320) by about 200 microns to about 600 microns for flood light projection onto the region of space.

4. The light projection apparatus (100,200,300) of any one of claims 1 to 3, **characterized in that** the DOE (130,230,330) is a two-dimensional fan out DOE.

5. The light projection apparatus (100,200,300) of any one of claims 1 to 4, **characterized in that** the light source (110,210,310) is a vertical cavity surface emitting laser (VCSEL) array.

6. The light projection apparatus (200) of any one of claims 1 to 5 **characterized by** further comprising:
a step motor (250) configured to adjust the position of the adjustable optical element (220) relative to the light source (210).

7. The light projection apparatus (300) of any one of claims 1 to 5, **characterized in that** the adjustable optical element (320) is a liquid crystal (LC) lens, and the light projection apparatus (300) further comprises:
an LC lens driver (350) configured to apply voltage signals on the LC lens to adjust an effective focal length of the LC lens.

8. The light projection apparatus (100,200,300) of any one of claims 1 to 7 **characterized by** further comprising:
a light sensor (140,240,340) configured to detect the light reflected at the region of space.

9. The light projection apparatus (100,200,300) of claim 8, **characterized in that** the light sensor (140,240,340) is a structured light sensor, a time of flight (ToF) sensor, or a combination thereof.

10. A light projection apparatus (400) **characterized by** comprising:
a first light source (410A) configured to emit first light;
a first optical element (420A) arranged over the first light source (410A) for refracting the first light, wherein the first light source (410A) is on a focus plane of the first optical element (420A);
a first diffractive optical element (DOE) (430A) arranged over the first optical element (420A) for diffracting the first light onto a region of space;
a second light source (410B) configured to emit second light;
a second optical element (420B) arranged over the second light source (410B) for refracting the second light, wherein the second light source (410B) is defocused from a focus plane of the second optical element (420B); and
a second DOE (430B) arranged over the second optical element (420B) for diffracting the second light onto the region of space;
wherein the first light source (410A) and the first optical element (420A) are respectively the same as the second light source (410B) and the second optical element (420B).

11. The light projection apparatus (400) of claim 10, **characterized in that** the first DOE (430A) and the second DOE (430B) are the same.

12. The light projection apparatus (400) of claim 10 or 11, **characterized in that** each of the first DOE (430A) and the second DOE (430B) is a two-dimensional fan out DOE.

13. The light projection apparatus (400) of any one of claims 10 to 12, **characterized in that** each of the first light source (410A) and the second light source (410B) is a vertical cavity surface emitting laser (VCSEL) array.

14. The light projection apparatus (400) of any one of claims 10 to 13 **characterized by** further comprising:
a light sensor (440) configured to detect the first light or the second light reflected at the region of space.

15. The light projection apparatus (400) of claim 14, **characterized in that** the light sensor (440) is a structured light sensor, a time of flight (ToF) sensor, or a combination thereof.
